# EUROPEAN PATENT APPLICATION

(11) **EP 4 460 162 A1**
(43) Date of publication of application: **06.11.2024**
(21) Application number: 23171461.9
(22) Date of filing: 04.05.2023
(51) Int. Cl.: H10B 10/00, H01L 29/06, H01L 21/822, H01L 21/8238, H01L 27/06, H01L 27/092, H01L 29/66, H01L 29/775

(54) **A HIGH PERFORMANCE AND LOW POWER 3D SRAM CELL AND PROCESS INTEGRATION FLOW**

(71) Applicant: Imec VZW, 3001 Leuven (BE); Katholieke Universiteit Leuven, 3000 Leuven (BE)
(72) Inventor: LIU, Hsiao-Hsuan, 3001 Leuven (BE); SALAHUDDIN, Shairfe Muhammad, 3001 Leuven (BE); CHAN, Boon Teik, 3001 Leuven (BE)
(74) Representative: Roth, Sebastian

(57) **Abstract**

The present disclosure relates to a three-dimensional (3D) static random access memory (SRAM), and provides a 3D SRAM cell and a method for processing transistors of the 3D SRAM cell. The SRAM cell comprise two PU transistors arranged in a first tier two PD transistors arranged in a second tier above or below the first tier, and two PG transistors arranged in the first tier or in the second tier. The PU transistors and PD transistors form a pair of cross-coupled inverters. In a first alternative, the transistors are fin transistors, each PU transistor has a first number of fins, each PD transistor has a second number of fins, and a ratio of the first number to the second number is 2:1 if the PG transistors are arranged in the first tier or is 1:2 if the PG transistors are arranged in the second tier. In a second alternative, the transistors are nanosheet-based transistors, each PU transistor has a first nanosheet width, each PD transistor has a second nanosheet width, and a ratio of the first to the second nanosheet width is 2:1 if the PG transistors are arranged in the first tier or is 1:2 if the PG transistors are arranged in the second tier.

## Description

### TECHNICAL FIELD

The present disclosure relates to three-dimensional (3D) static random access memory (SRAM). The disclosure provides a 3D SRAM cell, and a method for processing transistors of the 3D SRAM cell. The disclosure particularly provides solutions for both a high performance (HP) SRAM and a low power (LP) SRAM.

### BACKGROUND

SRAM is a form of semiconductor memory, which is widely used in electronics, microprocessors, and general computing applications. SRAM can store data in a static fashion, and does not need to be dynamically updated like other types of memory. SRAM comprises a plurality of SRAM cells, wherein each SRAM cell is configured to store one bit of data. A typical six transistor (6T) SRAM cell has four transistors for storing the bit - namely, two pull-up (PU) and two pull-down (PD) transistors, which are configured as two cross-coupled inverters. The cross-coupled inverters have two stable states, which determine the logical "0" and "1" states of the bit. In addition to the four transistors used for storing the bit, the typical 6T SRAM cell includes two further transistors (called pass gate (PG) transistors), which are used to control the access to the four transistors during a bit read or a bit write operation.

Nowadays, many methods of fabricating SRAM aim at reducing the cell area of the SRAM cell, and increasing its performance. For instance, stacked SRAM cells, in which the transistors of the SRAM cell are arranged in multiple tiers (or levels), which are stacked one above the other, could lead to a reduced cell area. As an example, a stacked SRAM cell may be fabricated using complementary field effect transistor (CFET) technology, wherein an n-type metal-oxide-semiconductor

(NMOS) transistor and a p-type metal-oxide-semiconductor (PMOS) transistor are processed together in a stacked manner - either monolithically or sequentially - and can then be cross-coupled to form the two cross-coupled inverters.

However, layout designs and interconnect solutions for such stacked SRAM cells, as well as process flows for fabricating transistors of such SRAM cells, still require optimization, in particular, in order to implement satisfying solutions for different kinds of SRAM, for instance, HP SRAM and LP SRAM.

### SUMMARY

An objective of this disclosure is thus to provide a layout design and interconnect solution for a stacked 6T SRAM cell for HP SRAM and for LP SRAM. Another objective is to provide method for processing the transistors of the SRAM cell, wherein the method is to be integrated with a process flow for fabricating the SRAM.

Another objective is to implement the SRAM cell with either nanosheet-based transistors or fin transistors. A particular objective is thereby to address the challenge of fabricating different fin transistors or nanosheet-based transistors in different tiers of the SRAM cell, for example, transistors with a different number of fins or different nanosheet widths. Another objective is to implement the SRAM cell using CFET technology. Thereby, both sequential and monolithic CFET should be supported by the method. For sequential CFET, the processing may be simpler, since a top tier and a bottom tier are fabricated separately followed by a bonding process. However, the top tier and the bottom tier are tied together in a monolithic CFET approach. Another objective is to develop the process flow beyond the 3 Å technology node (short "A3 node").

These and other objectives are achieved by the solutions of this disclosure described in the independent claims. Advantageous implementations are further described in the dependent claims.

A first aspect of this disclosure provides a 3D SRAM, cell comprising: two PU transistors arranged in a first tier of the SRAM cell; two PD transistors arranged in a second tier of the SRAM cell, the second tier being arranged above or below the first tier; wherein the two PU transistors and the two PD transistors form a pair of cross-coupled inverters; and two PG transistors arranged in the first tier or in the second tier; wherein in the SRAM cell: each transistor is a fin transistor, each PU transistor has a first number of fins, each PD transistor has a second number of fins, and a ratio of the first number to the second number is 2:1 if the PG transistors are arranged in the first tier or is 1:2 if the PG transistors are arranged in the second tier; or each transistor is a nanosheet-based transistor, each PU transistor has a first nanosheet width, each PD transistor has a second nanosheet width, and a ratio of the first to the second nanosheet width is 2:1 if the PG transistors are arranged in the first tier or is 1:2 if the PG transistors are arranged in the second tier.

As an example, the SRAM cell of the first aspect may be a monolithic 3D SRAM cell. The fin number ratio or the nanosheet width ratio is suitable to design the SRAM cell either for HP SRAM or for LP SRAM, wherein the fin number or nanosheet width of the PG transistors may differ for HP SRAM and LP SRAM, as will be described below.

The first aspect of this disclosure provides a layout design and interconnect solution for particularly a stacked 6T SRAM cell for either HP SRAM or LP SRAM. The SRAM cell according to the first aspect can be implemented using either nanosheet-based transistors or fin transistors. Fin transistors may be fin field effect transistors (FinFETs). Nanosheet-based transistors may be nanosheet transistors or forksheet transistors.

Notably, in this disclosure the terms "below" and "above", "bottom" and "top", or similar terms are to be interpreted relative to each other. In particular, these terms describe opposite sides of the SRAM cell, or opposite side of any element of the SRAM cell. The terms may describe a relationship of elements (e.g., transistor) of the SRAM cell along the direction of stacking. The direction of stacking may align with the arrangement of the first and the second tier of the SRAM cell. That is, the two (or more) tiers arranged above or below each other means that these tiers are arranged one after the other along a certain direction (the stacking direction).

Further, in this disclosure, the term "transistor" does not necessarily relate only to a fully processed and functional transistor, but relates also to an intermediate transistor structure, which may include the channel structure (e.g., the nanosheets or fins) of the final transistor, but may not (yet) include a gate or source/drain (SD) contacts, for example. That is, the term "transistor" in the aspects, implementations, and detailed embodiments of this disclosure includes an intermediate transistor structure.

In an implementation of the 3D SRAM cell, each PG transistor has a third number of fins, and the third number is equal to the first number or to the second number; or each PG transistor has a third nanosheet width, and the third nanosheet width is equal to the first or the second nanosheet width.

The third number of fins or the third nanosheet widths, respectively, may be selected depending on whether the SRAM cell is designed for HP SRAM or LP SRAM, as described by the following implementations.

In an implementation of the 3D SRAM cell, the SRAM cell is for a HP SRAM, and: a ratio of the first number to the third number to the second number is 2:2:1 if the PG transistors are arranged in the first tier or is 1:2:2 if the PG transistors are arranged in the second tier; or a ratio of the first nanosheet width to the third nanosheet width to the second nanosheet width is 2:2:1 if the PG transistors are arranged in the first tier or is 1:2:2 if the PG transistors are arranged in the second tier.

In an implementation of the 3D SRAM cell, the SRAM cell is for a LP SRAM and: a ratio of the first number to the third number to the first number is 2:1:1 if the PG transistors are arranged in the first tier or is 1:1:2 if the PG transistors are arranged in the second tier; or a ratio of the first nanosheet width to the third nanosheet width to the first nanosheet width is 2:1:1 if the PG transistors are arranged in the first tier or is 1:1:2 if the PG transistors are arranged in the second tier.

The SRAM cell for the HP SRAM has a faster speed, because of a stronger read path - either due to stronger PG and PD transistors in case of the 1:2:2 ratio and NMOS PG transistors or due to stronger PG and PU transistors in case of the 2:2:1 ratio and PMOS PG transistors. The SRAM cell for the LP SRAM has a better read stability, which provides higher potential of VDD scaling for a low power design.

In an implementation of the 3D SRAM cell, each PD transistor in the second tier is stacked directly above or below one of the PU transistors in the first tier; and/or each pair of one PU transistor in the first tier and one PD transistor in the second tier is based on a CFET.

Thus, the design of the SRAM cell of the first aspect is compatible with the use of CFET technology. Both monolithic and sequential CFET approaches may be used.

In an implementation of the 3D SRAM cell: if the PG transistors are arranged in the first tier, the PG transistors and the PU transistors in the first tier are PMOS transistors, and the PD transistors in the second tier are NMOS transistors; or if the PG transistors are arranged in the second tier, the PG transistors and the PD transistors in the second tier are NMOS, transistors, and the PU transistors in the first tier are PMOS transistors.

In an implementation of the 3D SRAM cell, a cross-coupling structure for the pair of cross-coupled inverters is arranged in the second tier directly above or below each of the PG transistors.

The cross-coupling connection of the PU and PD transistors can thus, beneficially, be formed in the freed-up space. This may allow a small footprint of the SRAM cell. The cross-coupling structure may be embedded in a dielectric material, which may be arranged in the space above the PG transistors, for example, may fill the space.

A second aspect of this disclosure provides a method for processing transistors of a 3D static random access, SRAM, cell, the method comprising: forming two PU transistors in a first tier of the SRAM cell; forming two PD transistors in a second tier of the SRAM cell, the second tier being formed above the first tier or the first tier being formed above the second tier; forming two PG transistors in the first tier or the second tier; connecting the two PU transistors and the two PD transistors to form a pair of cross-coupled inverters; and wherein: each transistor is a fin transistor, each PU transistor is formed to have a first number of fins, each PD transistor is formed to have a second number of fins, and a ratio of the first number to the second number is 2:1 if the PG transistors are arranged in the first tier or is 1:2 if the PG transistors are arranged in the second tier; or each transistor is a nanosheet-based transistor, each PU transistor is formed to have a first nanosheet width, each PD transistor is formed to have a second nanosheet width, and a ratio of the first to the second nanosheet width is 2:1 if the PG transistors are arranged in the first tier or is 1:2 if the PG transistors are arranged in the second tier.

The second aspect of this disclosure provides a process flow suitable for processing the transistors of the SRAM cell of the first aspect. The process flow particularly enables fabricating different kinds of fin transistors with a different number of fins, or different kinds of nanosheet-based transistors with different nanosheet widths. The process flow may be used in the A3 node.

In an implementation of the method: each PG transistor is formed to have a third number of fins, and the third number is equal to the first number or to the second number; or each PG transistor is formed to have a third nanosheet width, and the third nanosheet width is equal to the first or the second nanosheet width.

In an implementation, the method further comprises: forming two intermediate transistors in the second tier or first tier directly above or below the PG transistors in the first tier or second tier, respectively; removing at least a part of a channel structure of each intermediate transistor; and forming a cross-coupling structure for the pair of cross-coupled inverters in the spaces created by removing the at least part of the channel structure of each intermediate transistor.

Removing at least a part of the channel structure of an intermediate transistor may comprise removing at least a part of each fin or nanosheet of the intermediate transistor. For instance, this removal may be achieved by trench cutting, for example, combined with lithography. The spaces created by the removal can advantageously be used for forming the cross-coupling structure. This enables designing the SRAM cell with a small footprint (small cell area).

For example, removing the at least part of the channel structure of the intermediate transistor may comprise forming an opening (or trench) in a sacrificial gate arranged over the channel structure, and then forming a cut through the channel structure by etching the channel structure from the opening in the sacrificial gate. This may be referred to as trench cutting. The etching may extend completely through the channel structure, and may stop before reaching the channel structure of the PG transistor below of above the intermediate transistor in the other tier. As an example, the PG transistors and the intermediate transistors may be formed by using CFET technology, i.e., together as a CFET. Moreover, each pair of a PU transistors and a PD transistor of the SRAM cell may be formed by CFET technology, i.e. together as a CFET as already described above.

In an implementation of the method, all the transistors are fin transistors, and the method comprises: initially forming each PD transistor in the second tier with the same number of fins as the PU transistors in the first tier; and the method further comprises: removing at least one fin of each PD transistor, so as to reduce the number of fins of the PD transistor to the second number if the PG transistors are arranged in the first tier; or removing at least one fin of each PU transistor, so as to reduce the number of fins of the PU transistor to the first number if the PG transistors are arranged in the second tier.

The removal of the at least one fin of each PD transistor or each PU transistor may be done by trench cutting, for example, combined with lithography. According to this implementation, a process flow is provided that allows fabricating transistors with different numbers of fins in the top tier and the bottom tier (first and second tier), especially when CFET technology is used.

In an implementation, the method further comprises: initially forming each PG transistor in the first tier with the same number of fins as the PU transistors, or initially forming each PG transistor in the second tier with the same number of fins as the PD transistors; and further comprising: removing at least one fin of each PG transistor, so as to reduce the number of fins of the PG transistor to the second number if the PG transistors are formed in the first tier; or removing at least one fin of each PG transistor, so as to reduce the number of fins of the PG transistor to the first number if the PG transistors are formed in the second tier.

The removal of the at least one fin of the PG transistor or of each PG transistor may be done by trench cutting. Alternatively, it may be done by an active fin cut before any gate patterning is done. According to this implementation, a process flow is provided that allows fabricating transistors in the same tier with different numbers of fins.

In an implementation of the method, all the transistors are nanosheet-based transistors, and the method comprises: initially forming each PD transistor in the second tier with the same nanosheet width as the PU transistors in the first tier; and the method further comprises: reducing the nanosheet width of each PD transistor by isotropic trimming to the second nanosheet width if the PG transistors are arranged in the first tier; or reducing the nanosheet width of each PU transistor by isotropic trimming to the first nanosheet width if the PG transistors are arranged in the second tier.

Accordingly, a process flow is provided that allows fabricating transistors with different nanosheet widths in a top tier and a bottom tier (first and second tier), especially when CFET technology is used. The isotropic trimming may be done with or without lithography. Isotropic trimming may comprise isotropic etching of the nanosheets (from at least one side), to reduce the nanosheet width.

In an implementation, the method further comprises: initially forming each PG transistors in the first tier with the same nanosheet width as the PU transistors in the first tier; and further comprising: reducing the nanosheet width of each PG transistor by isotropic trimming to the second nanosheet width if the PG transistors are formed in the first tier; or reducing the nanosheet width of each PG transistor by isotropic trimming to the first nanosheet width if the PG transistors are formed in the second tier.

Accordingly, a process flow is provided that allows fabricating transistors in the same tier with different nanosheet widths. The trimming may be combined with lithography.

In an implementation of the method, the reduction of the number of fins of the PD transistors or, respectively, the isotropic trimming to reduce the nanosheet widths of the PD transistors, is performed at or during a replacement metal gate (RMG) process step of a fabrication process of the SRAM cell.

This enables an efficient integration of the method of the second aspect into the overall fabrication process of the SRAM cell. The method of the second aspect may generally achieve the same advantages as described for the SRAM cell of the first aspect.

Notably, this disclosure is not limited to an order of performing the various reductions of the numbers of fins, for example, of the PG transistors and PD transistors, or of performing the various trench cutting steps. Likewise, this disclosure is not limited to an order of performing the various trimmings, for example, of the nanosheets of the PG transistors and PD transistors.

### BRIEF DESCRIPTION OF THE DRAWINGS

The above described aspects and implementations are explained in the following description of embodiments with respect to the enclosed drawings:
- FIG. 1: shows an SRAM cell according to this disclosure and an interconnect solution for a HP fin-on-fin CFET SRAM.
- FIG. 2-3: show an exemplary process flow that may be used in processing the PU and PD transistors of the SRAM cell of FIG. 1.
- FIG. 4: shows an SRAM cell according to this disclosure and an interconnect solution for a LP fin-on-fin CFET SRAM.
- FIG. 5: shows an SRAM cell according to this disclosure and an interconnect solution for a HP nanosheet-on-nanosheet CFET SRAM.
- FIG. 6-7: shows an exemplary process flow that may be used in processing the PG transistors of the SRAM cell of FIG. 5.
- FIG. 8-9: show an exemplary process flow that may be used in processing the PU and PD transistors of the SRAM cell of FIG. 5
- FIG. 10: shows an SRAM cell according to this disclosure and an interconnect solution for a HP nanosheet-on-nanosheet CFET SRAM.
- FIG. 11: shows an SRAM cell according to this disclosure and an interconnect solution for a LP nanosheet-on-nanosheet CFET SRAM.
- FIG. 12-13: shows an exemplary process flow that may be used in processing the PG transistors of the SRAM cell of FIG. 10 or of FIG. 11.
- FIG. 14: shows an SRAM cell according to this disclosure and an interconnect solution for a HP forksheet-on-forksheet CFET SRAM.
- FIG. 15-16: shows an exemplary process flow that may be used in processing the PU and PD transistors of the SRAM cell of FIG. 14.
- FIG. 17: shows an SRAM cell according to this disclosure and an interconnect solution for a LP forksheet-on-forksheet CFET SRAM.
- FIG. 18: shows a method for fabricating transistors of any 3D CFET SRAM cell according to this disclosure.

### DETAILED DESCRIPTION OF EMBODIMENTS

The present disclosure proposes a layout design for a 3D SRAM cell with stacked transistors, i.e., transistors arranged in two different tiers. The SRAM cell is, in particular, a 6T SRAM cell. The SRAM cell comprises two PU transistors, two PD transistors, and two PG transistors. The two PU transistors are arranged in a first tier of the SRAM cell. The two PU transistors may thus be arranged in the same plane or layer, or for instance at the same distance to an underlying substrate layer. The two PD transistors are arranged in a second tier of the SRAM cell, which is arranged above or below the first tier, for instance. For instance, if the SRAM cell comprises the substrate layer, the first tier may be formed directly on the substrate layer, and the second tier may be formed directly on the first tier and/or above the first tier, i.e., having a larger distance to the substrate layer than the first tier. Alternatively, the second tier may be formed directly on the substrate layer, and the first tier may be formed directly on the second tier and/or above the second tier, i.e., having a larger distance to the substrate layer than the second tier.

The two PD transistors and the two PU transistors form a pair of cross-coupled inverters, like in a conventional SRAM cell. The pair of cross-coupled inverters may take two different states (defining "0" or "1"), and may thus store a bit of information, which is also like in a conventional SRAM cell. The two PG transistors may be either arranged in the first tier or in the second tier, and may allow to access the pair of cross-coupled inverters, which functions as in a conventional SRAM.

Typically, if the PG transistors are arranged in the first tier, the PG transistors and the PU transistors are PMOS transistors, and the PD transistors are NMOS transistors. If, however, the PG transistors are arranged in the second tier, the PG transistors and the PD transistors are typically NMOS transistors, and the PU transistors are PMOS transistors.

Each transistor of the SRAM cell may be a fin transistor (e.g., a FinFET) or a nanosheet-based transistor (e.g., a nanosheet transistor or a forksheet transistor). In the former case, each transistor has a certain number of one or more fins. In the latter case, each transistor comprises one or more nanosheets having a certain width. Generally, according to a concept of this disclosure, the PU transistors and the PD transistors have either a different number of fins or have different nanosheet widths. In particular, each PU transistor has a first number of fins and each PD transistor has a second number of fins, or each PU transistor has a first nanosheet width and each PD transistor has a second nanosheet width.

In the case of using fin transistors, a ratio of the first number of fins of the PU transistors to the second number of fins of the PD transistors is 2:1, if the PG transistors are arranged in the first tier (i.e., in the same tier as the PU transistors). Alternatively, the ratio of the first number of fins to the second number of fins is 1:2, if the PG transistors are arranged in the second tier (i.e., in the same tier as the PD transistors).

In the case of using nanosheet-based transistors, a ratio of the first nanosheet width of the PU transistors to the second nanosheet width of the PD transistors is 2:1, if the PG transistors are arranged in the first tier. Alternatively, the ratio of the first nanosheet width to the second nanosheet width is 1:2, if the PG transistors are arranged in the second tier.

The PG transistors may each have a third number of fins or a third nanosheet width, respectively. The third number of fins of the PG transistors may be equal to either the first number of fins of the PU transistors or to the second number of fins of the PD transistors. Similarly, the third nanosheet width may be equal to either the first nanosheet width of the PU transistors or the second nanosheet width of the PD transistors. The third number of fins or the third nanosheet width, respectively, depends on whether the SRAM cell is designed for a HP SRAM or a LP SRAM.

In the SRAM cell of this disclosure, the PD transistors may be formed directly above the PU transistors, or vice versa. For example, each PD transistor in the second tier may be stacked directly above or below one of the PU transistors in the first tier. Thereby, each stacked pair including one PU transistor in the first tier and one PD transistor in the second tier may be fabricated using CFET technology, i.e., may be implemented as a CFET. Either sequential or monolithic CFET technology may be used in this disclosure to process a CFET.

In the following, specific but exemplary embodiments of different SRAM cells according to this disclosure are described, as well as respective interconnect solutions in the SRAM cell. The transistors of the SRAM cell are either based on fin transistors, on nanosheet transistors, or on forksheet transistors in these embodiments, and CFET technology is used. The layout designs of the different SRAM cells are illustrated, and relevant process flows for fabricating the transistors of the SRAM cells are respectively shown and explained.

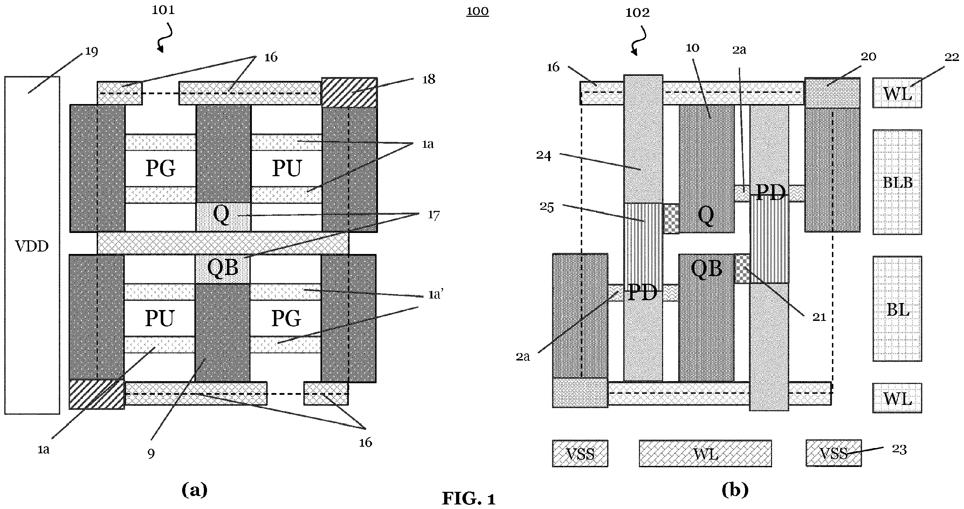

FIG. 1 shows an exemplary SRAM cell 100 of this disclosure for a HP fin-on-fin CFET SRAM. That is, the SRAM cell 100 of FIG. 1 is designed for a HP SRAM, is based on fin transistors, and may use monolithic CFET technology, for example, for implementing the PU and PD transistors. The SRAM cell is shown in a top view, wherein (a) is a view of the first tier 101, and (b) is a view of the second tier 102. The first tier 101 is arranged below the second tier 102 in this case (closer to an underlying substrate layer).

Since the SRAM cell of FIG. 1 is for a HP SRAM, and since the PG transistors are arranged in the first tier 101 together with the PU transistors, a ratio of the first number of fins of the PU transistors, to the third number of fins of the PG transistors, to the second number of fins of the PD transistors in the second tier 102 is 2:2:1. That is, the third number is equal to the first number in this case.

The fins 1a of the PU transistors and the fins 1a' of the PG transistors, respectively, form bottom transistor channels of these transistors, and may be implemented as silicon channels or as other suitable semiconductor material channels. The fins 2a of the PD transistors in the second tier 102 form top transistor channels, and may also be implemented as silicon channels or as other suitable semiconductor material channels. Notably, in the case of a nanosheet-based SRAM cell 100, these transistor channels would be formed by nanosheets, as shown in later figures. In sum, the fins or nanosheets may form a channel structure of the respective transistor.

The SRAM cell 100 shown in FIG. 1 further comprises a backside metal layer 19 arranged in or below the first tier 101, which may, for instance, be used to provide a supply voltage (VDD). Further, the SRAM cell 100 comprises a metal one (M1) layer 23 arranged in or above the second tier 101, which may, for instance, be used to provide a ground voltage (VSS). Further, the SRAM cell 100 comprises a metal intermediate (MINT) layer 22 formed in or above the second tier 102, which may, for instance, be used to implement word lines (WLs), and/or bit lines (BL), and/or bit lines bar (BLB).

The SRAM cell 100 of FIG. 1 may further comprise a dielectric isolation wall 16, for instance, to isolate the SRAM cell 100 from other SRAM cells or periphery in an SRAM. Further, nodes Q and QB are formed in the SRAM cell 100, similar as in a conventional SRAM cell, and an internal node merge 17 between a top and a bottom metal zero (Mo) layer may be provided, which may be used for forming the cross-coupling between the PU and PD transistors. Further, the SRAM cell 100 comprises a bottom SD epitaxial (Epi) structure 9 (e.g., comprising p-type silicon germanium) and a top SD epi structure 10 (e.g., comprising n-type silicon), which may be used to contact the nodes Q and QB.

Moreover, in the SRAM cell 100, at least a via 18 may provide a connection to a supply voltage (VDD) provided by a backside metal 19 or a backside power rail. Further, a supervia 20 may provide a connection to a front-side metal ground voltage (VSS). Moreover, the SRAM cell 100 may comprise a common gate 24, a gate extension 25 for the cross-coupled formation, and a spacer merge 21.

The SRAM cell of FIG. 1 is designed based on the use of CFET technology, and thus a stacked pair of a PU transistor in the first tier 101 and a PD transistor in the second tier 102 may be formed as a CFET. Thus, the SRAM cell 100 of FIG. 1 may be fabricated by initially forming each PD transistor in the second tier 102 with the same number of fins 2a as the PU transistors in the first tier 101, and then removing at least one fin 2a of each PD transistor, so as to reduce the number of fins 2a of the PD transistor to the second number.

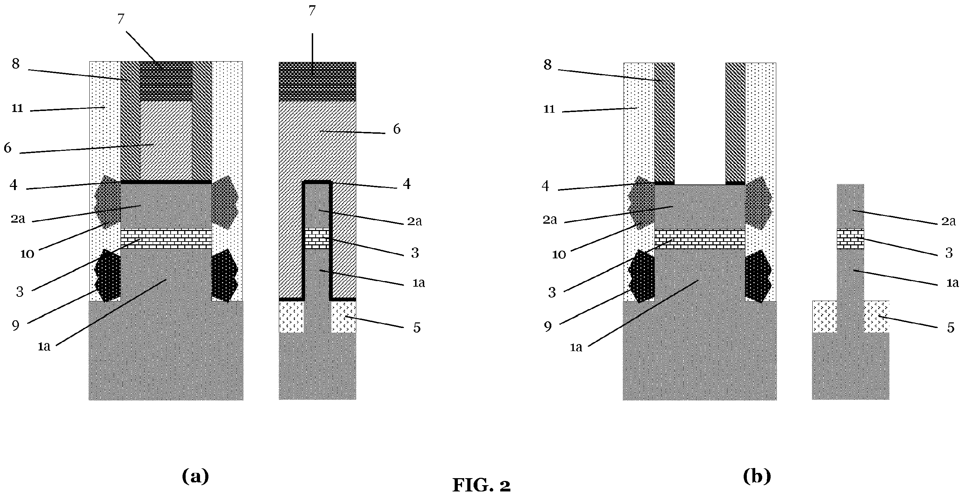

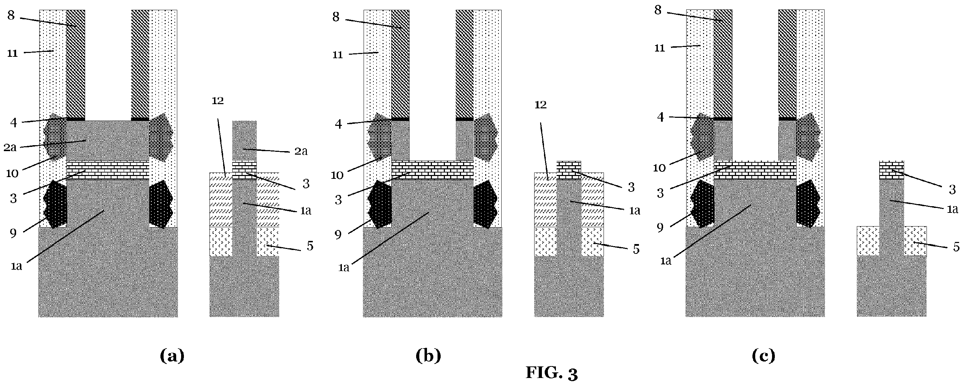

This may be done by using trench cutting. In particular, the SRAM cell 100 of FIG. 1 may be processed with the use of lithography to implement the trench cutting at a RMG process step of a fabrication process of the SRAM cell 100. Trench cutting at the RMG process step may mean implementing the trench cutting (for instance when removing a dummy gate stack) before forming a functional gate stack. In this respect, the FIGs. 2 and 3 show an exemplary process flow, which may be used in processing the PU and PD transistors of the SRAM cell 100 of FIG. 1.

FIG. 2(a) shows a fin structure in an intermediate SRAM cell (as it maybe formed after a step of chemical-mechanical polishing (CMP) of an interlayer dielectric (ILD) 11 in a fabrication process of the SRAM cell 100). The left side and the right side show two different (perpendicular) cross-sectional views of the intermediate SRAM cell. The fin structure is related to a pair of one PU transistor in the first (lower) tier 101 and one PD transistor in the second (upper) tier 102. The fin structure includes a fin 1a of the PU transistor and a fin 2a of the PD transistor. These fins 1a and 2a are separated by a middle dielectric isolation (MDI) 3, which maybe made of Si₃N₄, SiCO, SiCON, SiCN, or a dual dielectric material like an SiO₂ liner plus SiN, or a SiO₂ liner plus SiOCN. The fin structure is exemplarily formed on a substrate layer using a shallow trench isolation (STI) oxide 5. The upper fin 2a of the PD transistor is contacted by the top SD Epi structure 10, and the lower fin 1a of the PU transistor is contacted by the bottom SD Epi structure 9.

The fin structure is surrounded by a dummy gate 6 (e.g., made of amorphous silicon or poly-silicon), wherein the fin structure is separated by a gate oxide 4 from the material of the dummy gate 6. On the dummy gate 6, a gate hardmask 7 is provided, which may be made of Si₃N₄ and/or SiO₂. The dummy gate 6 is further sandwiched by a gate spacer 8, which may be made of Si₃N₄, SiCO, SiCON, SiBCN, or SiOBCN. The fin structure and the dummy gate 6 are together further sandwiched by the ILD 11, which may be made of SiO₂.

FIG. 2(b) shows that in a next process step the dummy gate 6 and the gate hardmask 7 are removed.

FIG. 3(a) shows that in a next process step a spin-on-carbon (SoC) coating 12 is applied around the lower fin 1a, which belongs to the PU transistor, and also partly around the MDI 3. The SoC coating 12 may be applied around the whole fin structure at first, and may then be etched back without requiring lithography to expose the upper fin 2a.

FIG. 3(b) shows that in a next process step the trench cutting of the top fin 2a of the fin structure is performed, which belongs to the PD transistor. The trench cutting may comprise etching into the trench defined by the gate spacer 8 and the ILD 11, and may stop on the MDI 3 acting as an etch-stop.

FIG. 3(c) shows that in a next process step the SoC coating 12 is then stripped (removed).

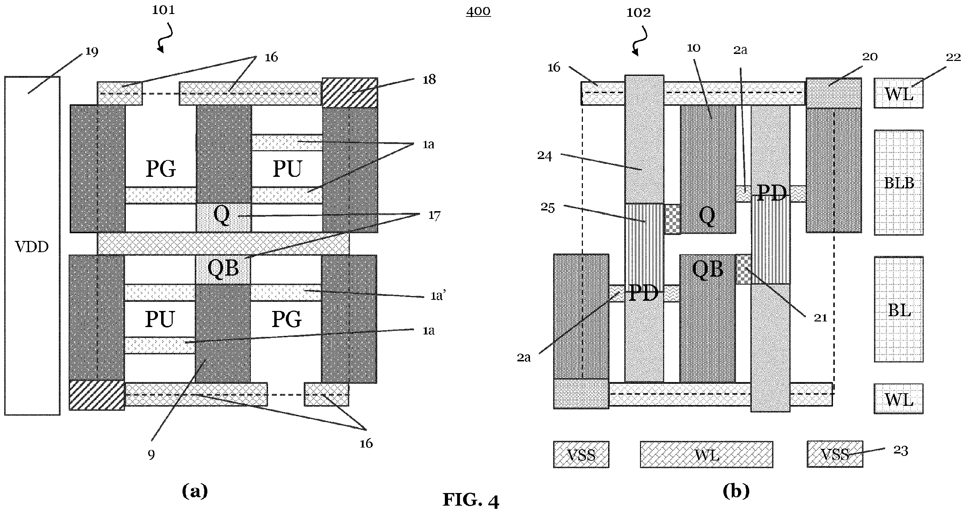

FIG. 4 shows an exemplary SRAM cell 400 of this disclosure for a LP fin-on-fin CFET SRAM. That is, the SRAM cell 400 of FIG. 4 is designed for a LP SRAM, is based on fin transistors, and may use monolithic CFET technology for implementing the PU and PD transistors. The SRAM cell 400 is shown in a top view, wherein (a) is a view of the first tier 101, and (b) is a view of the second tier 102. The first tier 101 is arranged below the second tier 102. Notably, the same elements in FIG. 1 and FIG. 4 have the same reference signs, are implemented likewise, and are thus not explained again with reference to the above explanations.

Since the SRAM cell 400 of FIG. 4 is for an LP SRAM, and since the PG transistors are arranged in the first tier 101 together with the PU transistors, a ratio of the first number of fins 1a of the PU transistors, to the third number of fins 1a' of the PG transistors, to the second number of fins 2a of the PD transistors in the second tier 102 is 2:1:1. That is, the third number is equal to the second number.

Notably, the SRAM cell of FIG. 4 may also employ the process flow shown in the FIGs. 2 and 3, in order to reduce the number of the fins 2a of the PD transistors to the second number, for example, by using the trench cutting. The PG transistors may be initially formed with the same number of fins as the PU transistors, and the number may be reduced to the final number of fins 1a' of the PG transistors by trench cutting or by performing an active cut before any (dummy) gate patterning.

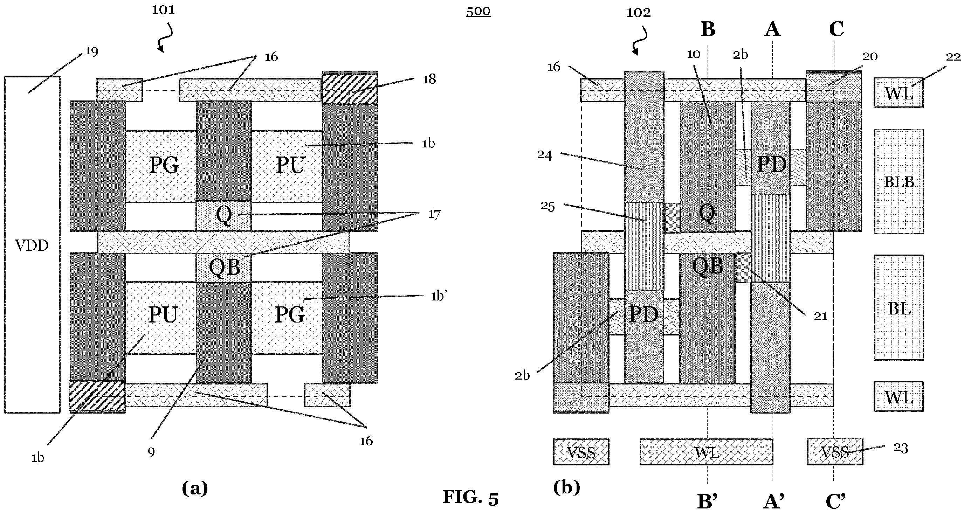

FIG. 5 shows an exemplary SRAM cell 500 of this disclosure for a HP nanosheet-on-nanosheet CFET SRAM. That is, the SRAM cell 500 of FIG. 5 is designed for a HP SRAM, is based on nanosheet transistors, and may use monolithic CFET for implementing the PU and PD transistors. The SRAM cell 500 is shown in a top view, wherein (a) is a view of the first tier 101, and (b) is a view of the second tier 102. The first tier 101 is arranged below the second tier 102. Notably, the same elements in FIG. 1 and FIG. 5 have the same reference signs, are implemented likewise, and are not explained again with reference to the above explanations.

Since the SRAM cell 500 of FIG. 5 is for an HP SRAM, and since the PG transistors are arranged in the first tier 101 together with the PU transistors, a ratio of the first nanosheet width of the nanosheets 1b of the PU transistors, to the third nanosheet width of the nanosheets 1b' of the PG transistors, to the second nanosheet width of the nanosheets 2b of the PD transistors, is 2:2:1. That is, the third nanosheet width is equal to the first nanosheet width.

The SRAM cell 500 of FIG. 5 may be fabricated using CFET technology, and thus the PG transistors may at first be formed as a CFET. Thus, the SRAM cell 500 of FIG. 5 may be fabricated by forming two intermediate ("PG") transistors in the second tier 102 directly above the PG transistors in the first tier 101, and then removing at least a part of a channel structure of each intermediate transistor. Further, a cross-coupling structure for the pair of cross-coupled inverters may be formed in the spaces created by removing the at least parts of the channel structures of the intermediate transistors.

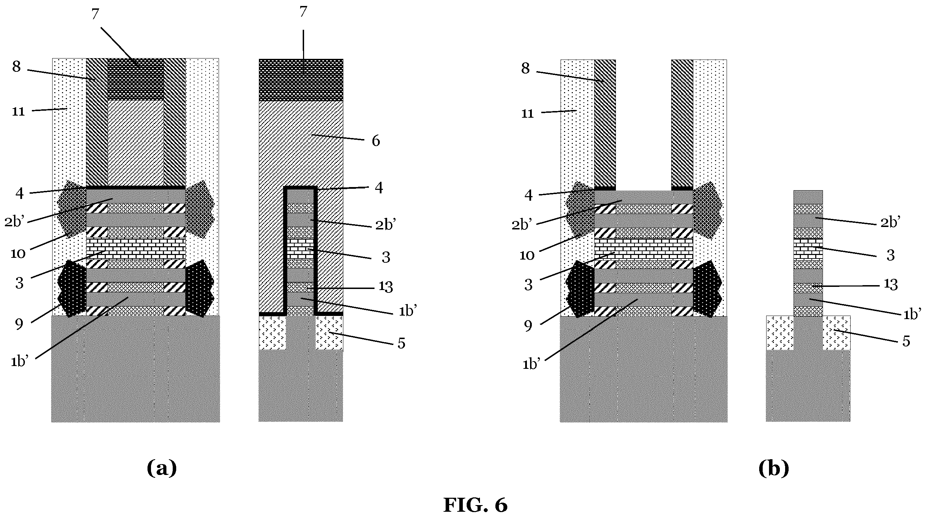

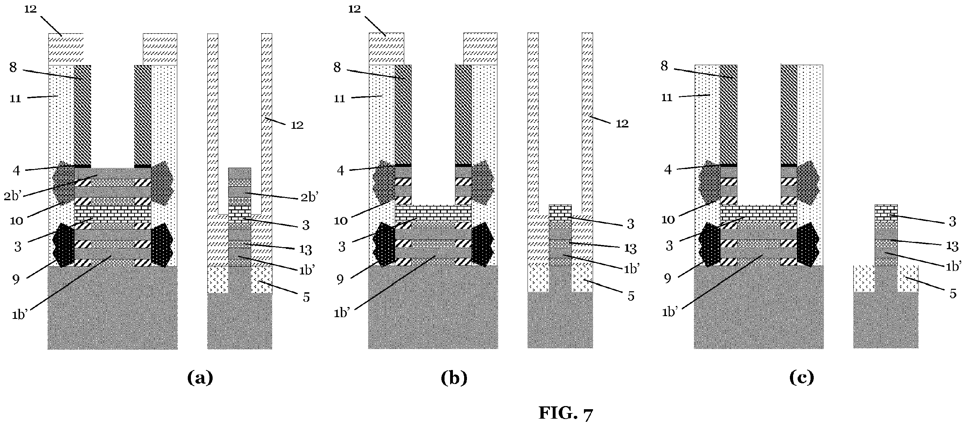

This removal may be done by trench cutting. In particular, the removal may be done by trench cutting combined with lithography and may be implemented at the RMG process step of a fabrication process of the SRAM cell 500. In this respect, the FIGs. 6 and 7 show an exemplary process flow, which maybe used in processing the PG transistors of the SRAM cell 500 of FIG. 5. Notably, the same or a similar process may be used for all other SRAM cells presented in this disclosure, in order to fabricate the PG transistors by CFET technology, but finally have PG transistors only in the first tier 101.

FIG. 6(a) shows a nanosheet structure in an intermediate SRAM cell (as it may be formed after a step of CMP of an ILD 11 in a fabrication process of the SRAM cell 500). The left side and the right side show two different (perpendicular) cross-sectional views of the intermediate SRAM cell. The nanosheet structure is related to a PG transistor in the first (lower) tier 101 and an intermediate "PG" transistor in the second (upper) tier 102. The nanosheet structure includes nanosheets 1b' of the PG transistor and nanosheets 2b' of the intermediate transistor. These nanosheets 1b' and 2b' are separated by a MDI 3. The nanosheet structure is exemplarily formed on a substrate layer using a shallow STI oxide 5. The upper nanosheets 2b' of the intermediate transistor is contacted by a top SD Epi structure 10, and the lower nanosheets 1b' of the PG transistor is contacted by a bottom SD Epi structure 9. The dummy gate 6, gate hardmask 7, gate spacer 8, and ILD 11 are as in FIG. 2.

FIG. 6(b) shows that in a next process step the dummy gate 6 and the gate hardmask 7 are removed.

FIG. 7(a) shows that in a next process step a SoC coating 12 is applied around the lower nanosheets 1b', which belongs to the PG transistor, and also partly around the MDI 3. The SoC coating 12 may be formed around the entire nanosheet structure at first, and may then be etched, e.g. using lithography, to expose the top nanosheets 2b' of the intermediate transistor.

FIG. 7(b) shows that in a next process step the trench cutting of the top nanosheets 2b' of the nanosheet structure is performed, which belongs to the intermediate transistor. The trench cutting may comprise etching, wherein the trench is defined by the gate spacer 8 and the ILD 11, and may stop on the MDI 3. As in this case the top nanosheets 2b' form the channel structure of the intermediate transistor, the trench cutting removes at least a part of this channel structure (note that some parts of the top nanosheets 2b' may remain beneath the gate spacer 8). A similar process can be used if the channel structure is formed by fins.

FIG. 7(c) shows that in a next process step the SoC coating 12 is then stripped (removed).

As the SRAM cell 500 of FIG. 5 may be fabricated by CFET technology, a stacked pair of a PU transistor in the first tier 101 and a PD transistor in the second tier 102 may be formed as a CFET. Thus, the SRAM cell 500 of FIG. 5 may be fabricated by initially forming each PD transistor in the second tier 102 with nanosheets 2b having the same nanosheet width as the nanosheets 1b of the PU transistors in the first tier 101, and then reducing the nanosheet width of the nanosheets 2b of each PD transistor to the second nanosheet width.

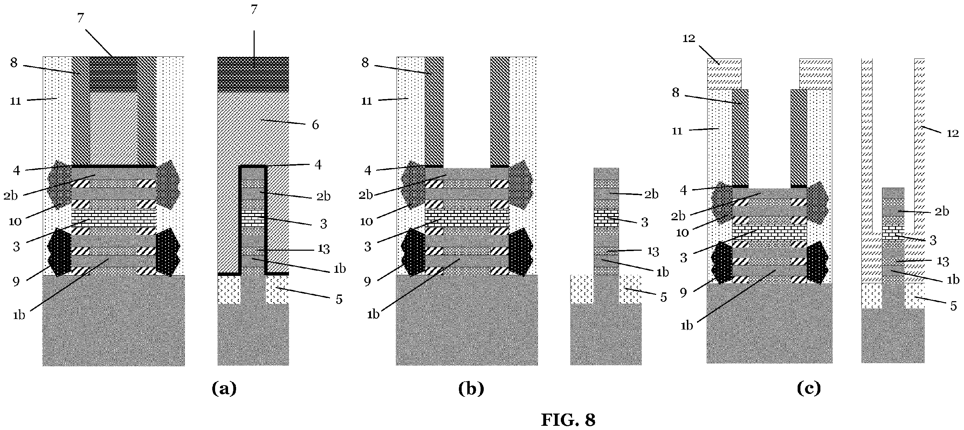

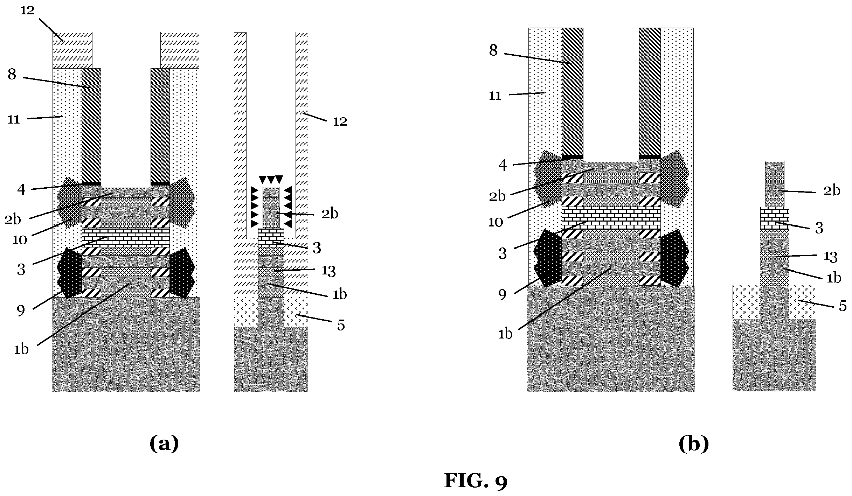

This may be done by isotropic trimming. In particular, the SRAM cell 500 of FIG. 5 may be processed using lithography at the RMG process step of a fabrication process of the SRAM cell 500. In this respect, the FIGs. 8 and 9 show an exemplary process flow that maybe used in processing the PU and PD transistors of the SRAM cell 500 of FIG. 5.

FIG. 8(a) shows a nanosheet structure in an intermediate SRAM cell (as it may be after a step of CMP of an ILD 11 in a fabrication process of the SRAM cell 500). The left side and the right side show two different (perpendicular) cross-sectional views of the intermediate SRAM cell. The nanosheet structure is related to a PU transistor in the first (lower) tier 101 and a PD transistor in the second (upper) tier 102. The nanosheet structure includes nanosheets 1b of the PU transistor and nanosheets 2b of the PD transistor. These nanosheets 1b and 2b are separated by MDI 3, similar to the nanosheets in FIG. 6. The nanosheet structure is exemplarily formed again on a substrate layer using a shallow STI oxide 5. The upper nanosheets 2b of the PD transistor are contacted by a top SD Epi structure 10, and the lower nanosheets 1b of the PU transistor are contacted by a bottom SD Epi structure 9. The dummy gate 6, gate hardmask 7, gate spacer 8, and ILD 11 are as in FIG. 6.

FIG. 8(b) shows that in a next process step the dummy gate 6 and the gate hardmask 7 are removed.

FIG. 8(c) shows that in a next process step a SoC coating 12 is applied around the lower nanosheets 1b, which belongs to the PU transistor, and also partly around the MDI 3. The SoC coating 12 may be formed around the entire nanosheet structure at first, and may then be etched, e.g. using lithography, to expose the top nanosheet 2b of the PD transistor.

Notably, the steps of FIG. 8(a)-(c) may be performed simultaneously to the steps of FIG. 6(a), 6(b) and 7(a).

FIG. 9(a) shows that in a next process step the isotropic trimming of the nanosheets 2b is performed, which belongs to the PD transistor. The isotropic trimming may comprise etching that is isotropic from all sides, wherein the etching may not affect the MDI 3. The etching of the isotropic trimming may take place in the opening of the SoC coating 12.

FIG. 9(b) shows that in a next process step the SoC 12 is then stripped (removed).

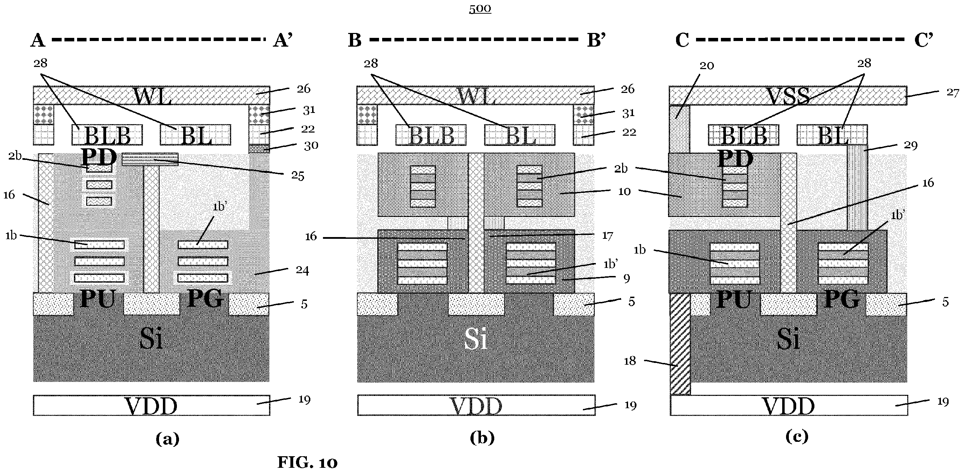

FIG. 10 shows the SRAM cell 500 for the HP nanosheet-on-nanosheet CFET SRAM in cross-sectional view along cuts between A-A', B-B' and C-C' indicated in FIG. 5. The ratio of the first nanosheet width of the nanosheets 1b of the PU transistors, to the third nanosheet width of the nanosheets 1b' of the PG transistors, to the second nanosheet width of the nanosheets 2b of the PD transistors, of 2:2:1 is schematically illustrated. The nanosheets 1b of the PU transistors in the first tier 101 and the nanosheets 2b of the PD transistors in the second tier 102 accordingly have different widths. It can be seen, how the PD transistors are arranged directly above the PU transistors, and how the PG transistors are arranged next to the PU transistors in the first tier 101.

Moreover, the first tier 101 including the PU transistors and PG transistors is arranged on a (e.g., silicon) substrate layer. The backside supply voltage VDD is provided beneath this substrate layer. The backside supply voltage may be provided by a backside metal 19 and a via 18, or may be provided by a backside power rail and corresponding power rail via (not shown). The shallow trench isolations 5 are formed in the substrate layer.

The bit lines 28 are arranged above the second tier 102, and the word line 26 is arranged above the bit lines 29. The word line 26 is connected by a Vo via (MINT to M1) 30, the MINT layer 22, and a VINT via (gate to MINT) to the common gate 24.

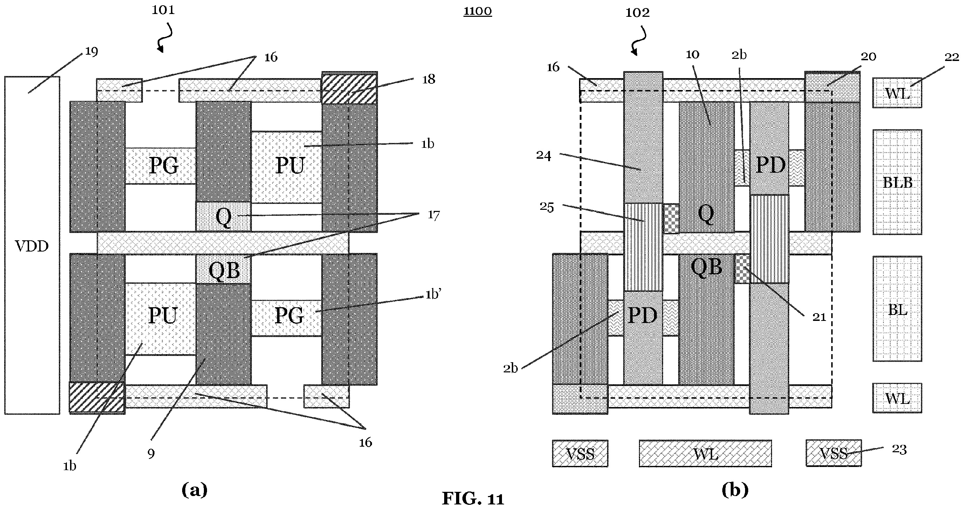

FIG. 11 shows an exemplary SRAM cell 1100 for a LP nanosheet-on-nanosheet CFET SRAM. That is, the SRAM cell 1100 of FIG. 11 is designed for a LP SRAM, is based on nanosheet transistors, and may use monolithic CFET technology for implementing the PU and PD transistors. The SRAM cell 1100 is shown in a top view, wherein (a) is a view of the first tier 101, and (b) is a view of the second tier 102. The first tier 101 is arranged below the second tier 102. Notably, the same elements in FIG. 1 and FIG. 11 have the same reference signs, are implemented likewise, and are not explained again with reference to the above explanations.

Since the SRAM cell 1100 of FIG. 11 is for an LP SRAM, and since the PG transistors are arranged in the first tier 101 together with the PU transistors, a ratio of the first nanosheet width of the nanosheets 1b of the PU transistors, to the third nanosheet width of the nanosheets 1b' of the PG transistors, to the second nanosheet width of the nanosheets 2b of the PD transistors, is 2:1:1. That is, the third nanosheet width is equal to the second nanosheet width.

As the SRAM cell of FIG. 11 is for a LP SRAM, the nanosheet width of the nanosheets 1b' of the PG transistors is smaller than the nanosheet width of the nanosheets 1b of the PU transistors arranged in the same (first) tier 101. Fabricating the SRAM cell 1100 of FIG. 11 may thus comprise initially forming each PG transistor in the first tier 101 with the same nanosheet width as the PU transistors in the first tier 101, and then reducing the nanosheet width of the nanosheets 1b' of each PG transistor to the second nanosheet width of the PD transistors in the second tier 102.

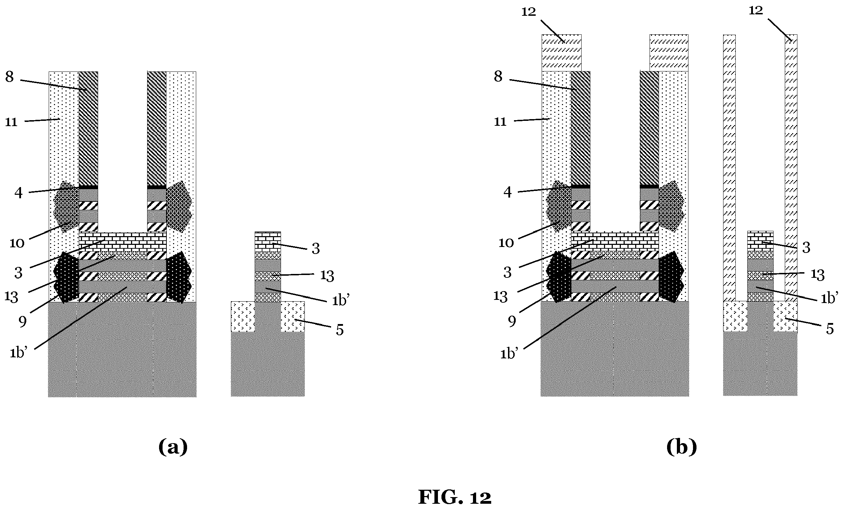

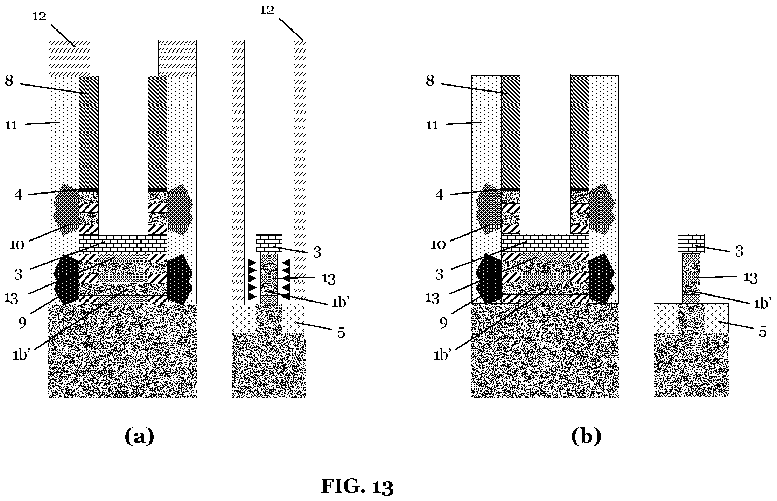

This may be done by isotropic trimming. In particular, the SRAM cell 1100 of FIG. 11 may use trimming combined with lithography for the bottom nanosheets 1b' at the RMG process step of a fabrication process of the SRAM cell 1100. In this respect, the FIGs. 12 and 13 show an exemplary process flow that may be used in processing the PG transistors of the SRAM cell 1100 of FIG. 11.

FIG. 12(a) shows a nanosheet structure in an intermediate SRAM cell (as it maybe in FIG. 7(c) after removing the SoC coating 12). The left side and the right side show two different (perpendicular) cross-sectional views of the intermediate SRAM cell. The nanosheet structure is related to the PG transistor in the first (lower) tier 101 and includes the nanosheets 1b' of the PG transistor. These nanosheets 1b' are topped by the MDI 3.

FIG. 12(b) shows that in a next process step a SoC coating 12 is again applied around the nanosheet structure, which belongs to the PG transistor. The SoC coating 12 may be formed around the entire nanosheet structure at first, and may then be etched, e.g. using lithography, to expose the bottom nanosheet 1b' of the PG transistor.

FIG. 13(a) shows that in a next process step the isotropic trimming of the bottom nanosheet 1b' of the PG transistor is performed. The isotropic trimming may comprise etching in an isotropic manner from all sides, wherein the etching may not etch the MDI 3. The etching may be confined by the SoC coating 12.

FIG. 13(b) shows that in a next process step the SoC coating 12 is then stripped (removed).

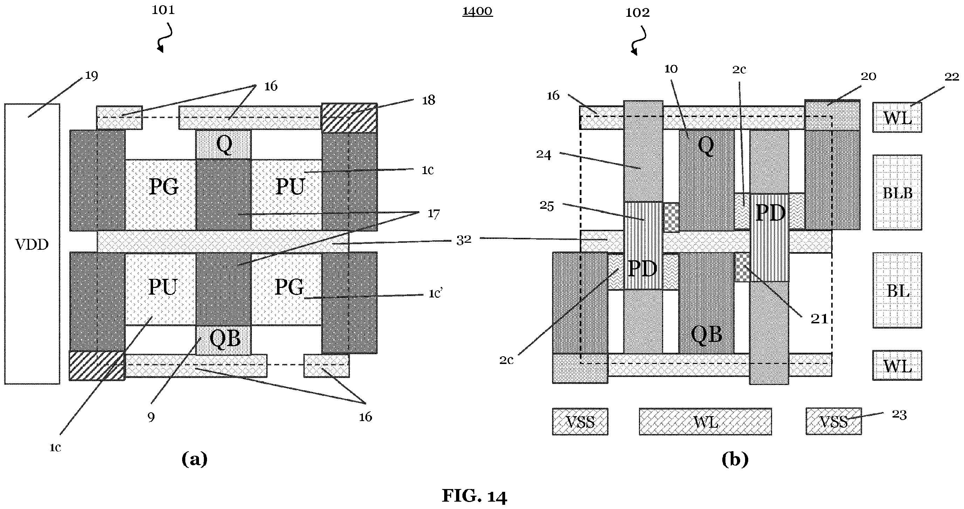

FIG. 14 shows an SRAM cell 1400 for a HP forksheet-on-forksheet CFET SRAM. That is, the SRAM cell 1400 of FIG. 14 is designed of or a HP SRAM, is based on forksheet transistors, and uses monolithic CFET for implementing the PU and PD transistors. The SRAM cell 1400 is shown in a top view, wherein (a) is a view of the first tier 101, and (b) is a view of the second tier 102. The first tier 101 is arranged below the second tier 102. Notably, the same elements in FIG. 1 and FIG. 14 have the same reference signs, are implemented likewise, and are not explained again.

Since the SRAM cell 1400 is for an HP SRAM, and since the PG transistors are arranged in the first tier 101 in FIG. 14 together with the PU transistors, a ratio of the first nanosheet width of the nanosheets 1c of the PU transistors, to the third nanosheet width of the nanosheets 1c' of the PG transistors, to the second nanosheet width of the nanosheets 2c of the PD transistors, is 2:2:1. That is, the third nanosheet width is equal to the first nanosheet width.

As the SRAM cell 1400 of FIG. 14 uses forksheet transistors, neighboring transistors in the first tier 101 may be processed together by a forksheet process, which comprises the formation of a dielectric wall 32, that separates a nanosheet structure into a first and a second nanosheet structure.

As the SRAM cell 1400 of FIG. 14 may be fabricated using CFET technology, a pair of a PU transistor in the first tier 101 and a PD transistor in the second tier 102 may be formed as a CFET. Thus, the dielectric wall 32 is also present in the second tier 102. Further, the SRAM cell 1400 of FIG. 14 may thus be fabricated by initially forming each PD transistor in the second tier 102 with the same nanosheet width as the PU transistors in the first tier 101, and then reducing the nanosheet width of the nanosheets 2c of each PD transistor to the second nanosheet width.

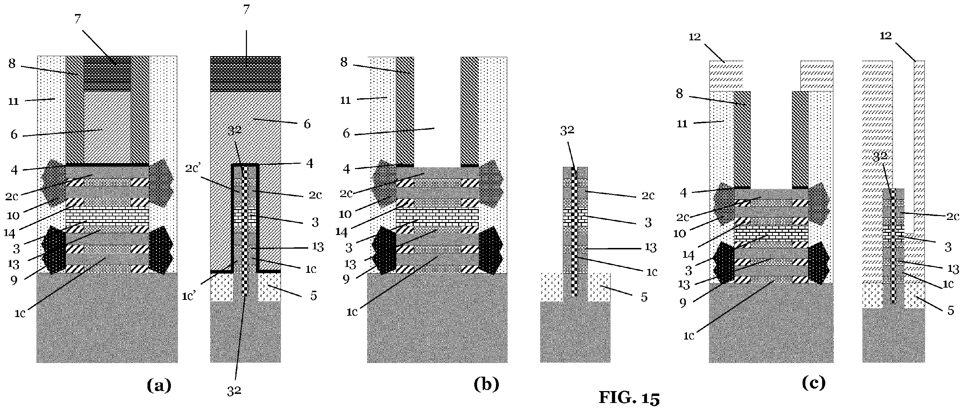

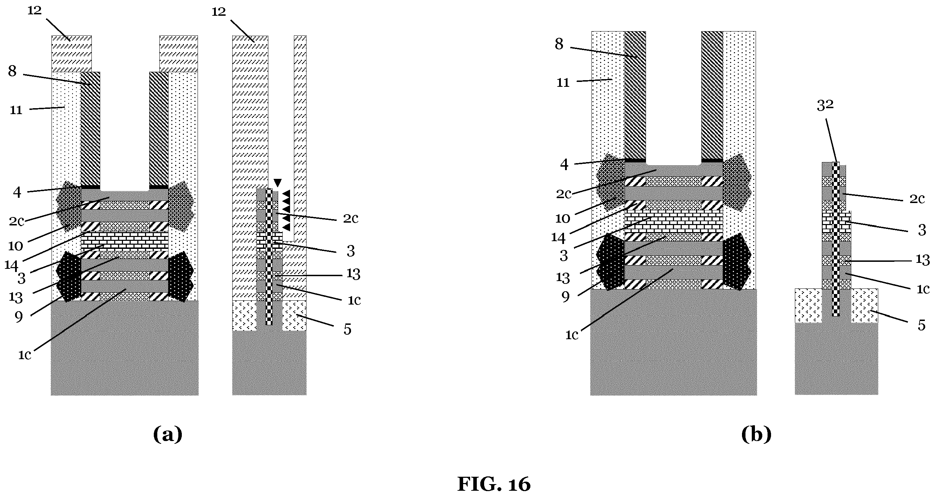

This may be done by isotropic trimming, wherein the trimming may be from one side, i.e., single-side trimming, since the PD transistors are forksheet transistors and the other side is delimited by the dielectric wall 32. In particular, the SRAM cell 1400 of FIG. 14 may be processed using a single-side trimming combined with lithography at the RMG process step of a fabrication process of the SRAM cell 1400. In this respect, the FIGs. 15 and 16 show an exemplary process flow that may be used in processing the PU and PD transistors of the SRAM cell 1400 of FIG. 14.

FIG. 15(a) shows a forksheet structure in an intermediate SRAM cell (as it may be after a step of CMP of an ILD 11 in a fabrication process of the SRAM cell 500). The left side and the right side show two different (perpendicular) cross-sectional views of the intermediate SRAM cell. The forksheet structure is related to a PU transistor and a PG transistor in the first (lower) tier 101 separated by the dielectric wall 32, and to a PD transistor and an intermediate "PG" transistor in the second (upper) tier 102 separated by the dielectric wall 32. The forksheet structure includes nanosheets 1c of the PU transistor, nanosheets 1c' of the PG transistor, nanosheets 2b of the PD transistor, and nanosheets 2b' of the intermediate transistor. These nanosheets 1c, 1c', 2c and 2c' are separated by MDI 3. The forksheet structure is exemplarily formed on a substrate layer using a shallow STI oxide 5. The upper nanosheets 2c and 2c' are contacted by a top SD Epi structure 10, and the lower nanosheets 1c and 1c' are contacted by a bottom SD Epi structure 9. The dummy gate 6, gate hardmask 7, gate spacer 8, and ILD 11 are as, e.g., in FIG. 5.

FIG. 15(b) shows that in a next process step the dummy gate 6 and the gate hardmask 7 are removed.

FIG. 15(c) shows that in a next process step a SoC coating 12 is applied around the lower nanosheets 1c and 1c', which belong to the PG transistor and PU transistor, and also partly around the MDI 3. The SOC coating 12 may be formed around the entire nanosheet structure at first, and may then be etched, e.g. using lithography, to expose the top nanosheets 2c of the PD transistor.

FIG. 16(a) shows that in a next process step the single-side trimming of the top nanosheets 2c of the forksheet structure is performed, which belongs to the PD transistor. The trimming may comprise etching in an isotropic manner from one side, wherein the etching may not affect the MDI 3 and SoC coating 12. The etching may thus be confined by the SoC coating 12.

FIG. 16(b) shows that in a next process step the SoC coating 12 is then stripped (removed).

In a further processing step (not shown), the top nanosheets 2c' of the intermediate ("PG") transistor may be removed, e.g. by a similar single-side trimming step.

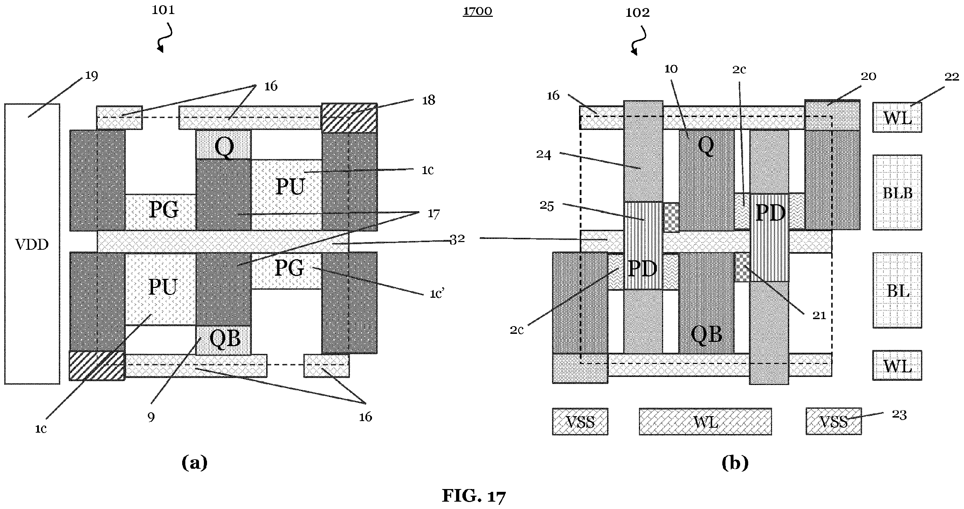

FIG. 17 shows an SRAM cell 1700 for a LP forksheet-on-forksheet CFET SRAM. That is, the SRAM cell 1700 of FIG. 17 is designed for a LP SRAM, is based on forksheet transistors, and may use monolithic CFET for implementing the PU and PD transistors. The SRAM cell 1700 is shown in a top view, wherein (a) is a view of the first tier 101, and (b) is a view of the second tier 102. The first tier 101 is arranged below the second tier 102. Notably, the same elements in FIG. 1 and FIG. 17 have the same reference signs, are implemented likewise, and are not explained again with reference to the above explanations.

Since the SRAM cell 1700 is for an LP SRAM, and since the PG transistors are arranged in the first tier 101 together with the PU transistors, a ratio of the first nanosheet width of the nanosheets 1c of the PU transistors, to the third nanosheet width of the nanosheets 1c' of the PG transistors, to the second nanosheet width of the nanosheets 2c of the PD transistors, is 2:1:1. That is, the third nanosheet width is equal to the second nanosheet width.

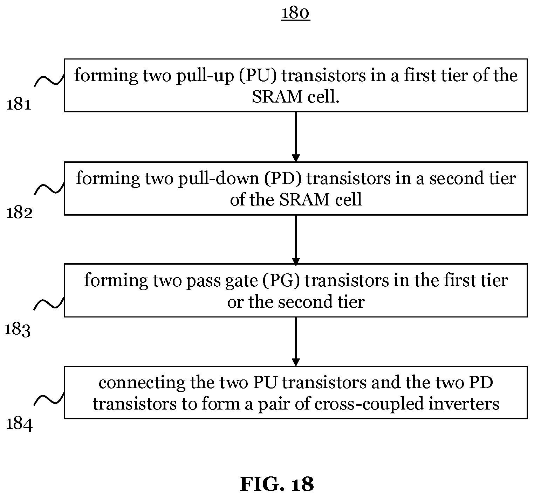

FIG. 18 shows a method 180 according to this disclosure, which may generally be used to fabricate any of the SRAM cells 100, 400, 500, 1100, 1400 and 1700 described in this disclosure. The method 180 comprises a step 181 of forming the two PU transistors in the first tier 101, and a step 182 of forming the two PD transistors in the second tier 102. Further, the method 180 comprises a step 183 of forming the two PG transistors in the first tier 101 or the second tier 102. The method 180 also comprises a step 184 of connecting the two PU transistors and the two PD transistors to form a pair of cross-coupled inverters.

The method 180 may form each transistor as a fin transistor. In this case each PU transistor is formed to have the first number of fins 1a, each PD transistor is formed to have the second number of fins 2a, and a ratio of the first number to the second number is 2:1, if the PG transistors (with fins 1a') are arranged in the first tier 101, or is 1:2 if the PG transistors are arranged in the second tier 102.

The method 180 may also form each transistor as a nanosheet-based transistor. In this case, each PU transistor is formed to have nanosheets 1b or 1c of a first nanosheet width, each PD transistor is formed to have nanosheets 2b or 2c of a second nanosheet width, and a ratio of the first to the second nanosheet width is 2:1, if the PG transistors (having nanosheets 2b' of 2c') are arranged in the first tier 101, or is 1:2 if the PG transistors are arranged in the second tier 102.

The design layouts of the SRAM cells 100, 400, 500, 1100, 1400 and 1700 described in this disclosure are beneficial, as their adaption to LP and HP can be done by changing the fin number or nanosheet width, in order to change the driver strengths. This can be achieved by an efficient method 180 and process flows. To the contrary, changing the fin heights or the number of nanosheet stacks at the same nanosheet width, to achieve different driver strength, would be more challenging or even not possible, due to logic fabrication at the same time.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A three-dimensional, 3D, static random access memory, SRAM, cell (100, 400, 500, 1100, 1400, 1700) comprising:
two pull-up, PU, transistors arranged in a first tier (101) of the SRAM cell (100, 400, 500, 1100, 1400, 1700);
two pull-down, PD, transistors arranged in a second tier (102) of the SRAM cell (100, 400, 500, 1100, 1400, 1700), the second tier (102) being arranged above or below the first tier (101);
wherein the two PU transistors and the two PD transistors form a pair of cross-coupled inverters; and
two pass gate, PG, transistors arranged in the first tier (101) or in the second tier (102);
wherein in the SRAM cell (100, 400, 500, 1100, 1400, 1700):
each transistor is a fin transistor, each PU transistor has a first number of fins (1a), each PD transistor has a second number of fins (2b), and a ratio of the first number to the second number is 2:1 if the PG transistors are arranged in the first tier (101) or is 1:2 if the PG transistors are arranged in the second tier (102); or
each transistor is a nanosheet-based transistor, each PU transistor has a first nanosheet (1b, 1c) width, each PD transistor has a second nanosheet (2b, 2c) width, and a ratio of the first to the second nanosheet width is 2:1 if the PG transistors are arranged in the first tier (101) or is 1:2 if the PG transistors are arranged in the second tier (102).

2. The 3D SRAM cell (100, 400, 500, 1100, 1400, 1700) according to claim 1, wherein:
each PG transistor has a third number of fins (1a'), and the third number is equal to the first number or to the second number; or
each PG transistor has a third nanosheet (1b', 1c') width, and the third nanosheet width is equal to the first or the second nanosheet width.

3. The 3D SRAM cell (100, 500, 1400) according to claim 2, wherein the SRAM cell (100, 500, 1400) is for a high performance, HP, SRAM, and:
a ratio of the first number to the third number to the second number is 2:2:1 if the PG transistors are arranged in the first tier (101) or is 1:2:2 if the PG transistors are arranged in the second tier (102); or
a ratio of the first nanosheet width to the third nanosheet width to the second nanosheet width is 2:2:1 if the PG transistors are arranged in the first tier (101) or is 1:2:2 if the PG transistors are arranged in the second tier (102).

4. The 3D SRAM cell (400, 1100, 1700) according to claim 2, wherein the SRAM cell (400, 1100, 1700) is for a low power, LP, SRAM, and:
a ratio of the first number to the third number to the first number is 2:1:1 if the PG transistors are arranged in the first tier (101) or is 1:1:2 if the PG transistors are arranged in the second tier (102); or
a ratio of the first nanosheet width to the third nanosheet width to the first nanosheet width is 2:1:1 if the PG transistors are arranged in the first tier (101) or is 1:1:2 if the PG transistors are arranged in the second tier (102).

5. The 3D SRAM cell (100, 400, 500, 1100, 1400, 1700) according to one of the claims 1 to 4, wherein:
each PD transistor in the second tier (102) is stacked directly above or below one of the PU transistors in the first tier (101); and/or
each pair of one PU transistor in the first tier (101) and one PD transistor in the second tier (102) is based on a complementary field effect transistor, CFET.

6. The 3D SRAM cell (100, 400, 500, 1100, 1400, 1700) according to one of the claims 1 to 5, wherein:
if the PG transistors are arranged in the first tier (101), the PG transistors and the PU transistors in the first tier (101) are p-type metal-oxide-semiconductor, PMOS, transistors, and the PD transistors in the second tier (102) are n-type metal-oxide-semiconductor, NMOS, transistors; or
if the PG transistors are arranged in the second tier (102), the PG transistors and the PD transistors in the second tier (102) are n-type metal-oxide-semiconductor, NMOS, transistors, and the PU transistors in the first tier (101) are p-type metal-oxide-semiconductor, PMOS, transistors.

7. The 3D SRAM cell (100, 400, 500, 1100, 1400, 1700) according to one of the claims 1 to 6, wherein a cross-coupling structure for the pair of cross-coupled inverters is arranged in the second tier (102) directly above or below each of the PG transistors.

8. A method (180) for processing transistors of a three-dimensional, 3D, static random access, SRAM, cell (1100, 400, 500, 1100, 1400, 1700), the method (180) comprising:
forming (181) two pull-up, PU, transistors in a first tier (101) of the SRAM cell (100, 400, 500, 1100, 1400, 1700);
forming (182) two pull-down, PD, transistors in a second tier (102) of the SRAM cell (100, 400, 500, 1100, 1400, 1700), the second tier (102) being formed above the first tier (101) or the first tier (101) being formed above the second tier (102);
forming two pass gate, PG, transistors in the first tier (101) or the second tier (102);
connecting the two PU transistors and the two PD transistors to form a pair of cross-coupled inverters; and
wherein:
each transistor is a fin transistor, each PU transistor is formed to have a first number of fins (1a), each PD transistor is formed to have a second number of fins (2a), and a ratio of the first number to the second number is 2:1 if the PG transistors are arranged in the first tier (101) or is 1:2 if the PG transistors are arranged in the second tier (102); or
each transistor is a nanosheet-based transistor, each PU transistor is formed to have a first nanosheet (1b, 1c) width, each PD transistor is formed to have a second nanosheet (2b, 2c) width, and a ratio of the first to the second nanosheet width is 2:1 if the PG transistors are arranged in the first tier (101) or is 1:2 if the PG transistors are arranged in the second tier (102).

9. The method (180) according to claim 8, wherein:
each PG transistor is formed to have a third number of fins (1a'), and the third number is equal to the first number or to the second number; or
each PG transistor is formed to have a third nanosheet (1b', 1c') width, and the third nanosheet width is equal to the first or the second nanosheet width.

10. The method (180) according to claim 8 or 9, further comprising:
forming two intermediate transistors (2c') in the second tier (102) or first tier (101) directly above or below the PG transistors in the first tier (101) or second tier (102), respectively;
removing at least a part of a channel structure of each intermediate transistor (2c'); and
forming a cross-coupling structure for the pair of cross-coupled inverters in the spaces created by removing the at least part of the channel structure of each intermediate transistor (2c').

11. The method (180) according to one of the claims 8 to 10, wherein all the transistors are fin transistors, and the method (180) comprises:
initially forming each PD transistor in the second tier (102) with the same number of fins (2a) as the PU transistors in the first tier (101); and the method (180) further comprises:
removing at least one fin (2a) of each PD transistor, so as to reduce the number of fins (2a) of the PD transistor to the second number if the PG transistors are arranged in the first tier (101); or
removing at least one fin (1a) of each PU transistor, so as to reduce the number of fins (1a) of the PU transistor to the first number if the PG transistors are arranged in the second tier (102).

12. The method (180) according to claim 11, further comprising:
initially forming each PG transistor in the first tier (101) with the same number of fins (1a') as the PU transistors, or initially forming each PG transistor in the second tier (102) with the same number of fins (1a') as the PD transistors; and further comprising:
removing at least one fin (1a') of each PG transistor, so as to reduce the number of fins (1a') of the PG transistor to the second number if the PG transistors are formed in the first tier (100); or
removing at least one fin (1a') of each PG transistor, so as to reduce the number of fins (1a') of the PG transistor to the first number if the PG transistors are formed in the second tier (102).

13. The method (180) according to one of the claims 8 to 10, wherein all the transistors are nanosheet-based transistors, and the method (180) comprises:
initially forming each PD transistor in the second tier (102) with the same nanosheet (2b, 2c) width as the PU transistors in the first tier (101); and the method (180) further comprises:
reducing the nanosheet (2b, 2c) width of each PD transistor by isotropic trimming to the second nanosheet width if the PG transistors are arranged in the first tier (101); or
reducing the nanosheet (2b) width of each PU transistor by isotropic trimming to the first nanosheet width if the PG transistors are arranged in the second tier (102).

14. The method (180) according to claim 13, further comprising:
initially forming each PG transistors in the first tier (101) with the same nanosheet (1b', 1c') width as the PU transistors in the first tier (101); and further comprising:
reducing the nanosheet (1b', 1c') width of each PG transistor by isotropic trimming to the second nanosheet width if the PG transistors are formed in the first tier (101); or
reducing the nanosheet (1b', 1c') width of each PG transistor by isotropic trimming to the first nanosheet width if the PG transistors are formed in the second tier (102).

15. The method (180) according to one of the claims 10 to 14, wherein:
the reduction of the number of fins (2a) of the PD transistors or, respectively, the isotropic trimming to reduce the nanosheet (2b, 2c) widths of the PD transistors, is performed at a replacement metal gate, RMG, process step of a fabrication process of the SRAM cell (100, 400, 500, 1100, 1400, 1700).
